# EUROPEAN PATENT SPECIFICATION

(11) **EP 1 619 697 B1**
(45) Date of publication and mention of the grant of the patent: **18.06.2008**
(21) Application number: 05014684.4
(22) Date of filing: 06.07.2005
(51) Int. Cl.: H01F 17/00

(54) **Low-loss inductor device and fabrication method thereof**
Verlustarme induktive Vorrichtung und Verfahren zu ihrer Herstellung
Dispositif inductif à faibles pertes et son procédé de fabrication

(30) Priority: 20.07.2004 KR 2004056468
(43) Date of publication of application: 25.01.2006
(73) Proprietor: SAMSUNG ELECTRONICS CO., LTD., Suwon-si, Gyeonggi-do (KR)
(72) Inventor: Lee, Moon-chul, Suwon-si Gyeonggi-do (KR); Choi, Hyung, Bundang-gu Seongnam-si Gyeonggi-do (KR)
(74) Representative: Grünecker, Kinkeldey, Stockmair & Schwanhäusser Anwaltssozietät

(56) References cited:
- EP-A- 0 413 348
- US-A1- 2002 019 079
- US-A1- 2002 192 920
- US-A1- 2004 032 011

## Description

### CROSS-REFERENCE TO RELATED APPLICATIONS

This application claims priority from Korean Patent Application 2004-56468, filed on July 20, 2004.

### BACKGROUND OF THE INVENTION

### Field of the Invention:

The present invention relates to an inductor device and, more particularly, to an inductor device and a fabrication method thereof capable of minimizing the loss of the inductor.

### Description of the Related Art:

The Micro-electro-mechanical system (MEMS) is the technology of implementing mechanical and/or electrical devices by using the semiconductor process. For example, the inductor device can be fabricated by use of the MEMS technology.

The inductor device is fabricated to supply magnetic fluxes or fields to a device requiring the magnetic fluxes or fields such as a capacitor in an LC resonance circuit. Therefore, a consideration factor in the inductor fabrication is to design an inductor device to supply all magnetic fluxes generated in the inductor to a device requiring the magnetic fluxes, but not to the other devices.

Therefore, two of the factors to consider in an inductor device are inductance and a quality factor. Currently, the inductance has been satisfactorily achieved to some extent, but the quality factor has not been achieved up to a desired value due to the substrate loss and the electric current limitation caused by DC resistance which occurs in an inductor device.

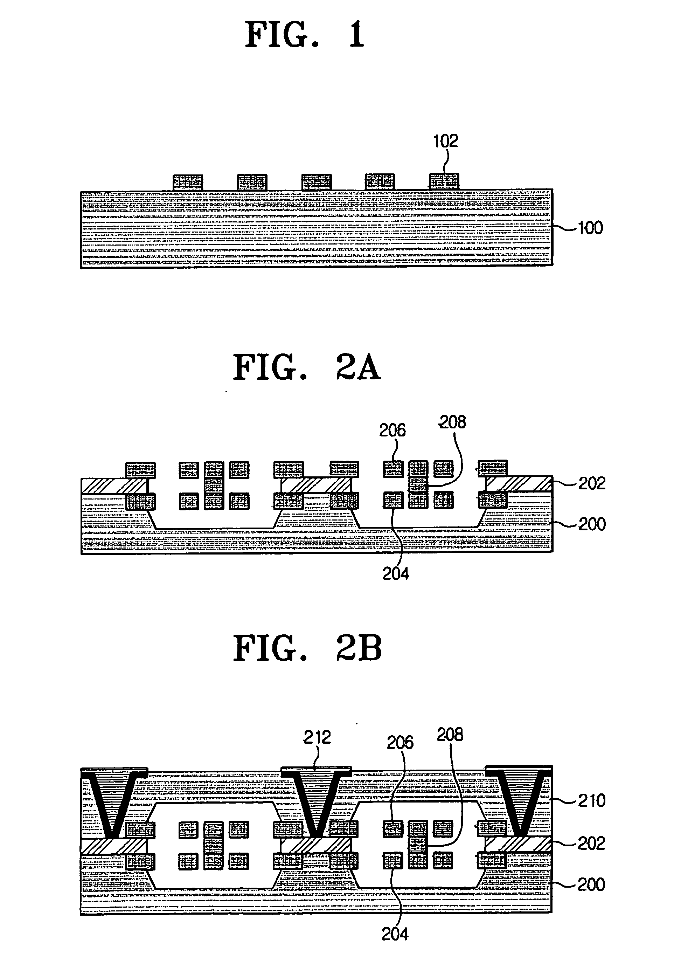

For example, as shown in FIG. 1, the conventional inductor device has an inductor L (102) integrated and formed on the substrate 100, so the parasitic effect is caused between the inductor 102 and the substrate 100 due to the direct contact of the inductor 102 with the substrate 100. The inductance of the inductor 102 becomes lowered due to the parasitic effect. In order to solve the problem of low inductance as above, an expensive low-dielectric substance has to be used.

An example for an inductor with conductive coils formed on both sides of a dielectric layer is disclosed in prior art document US 2004/032011 A1, which is regarded as the closest prior art. The inductor further comprises electrical connection parts, a protective shielding, and bond windows etched into the substrate, in order to provide through-holes for connecting the inductor coils via leads to a chip.

In consideration of the cost and the problem of low inductance due to the parasitic effect, there has been proposed a method of fabricating an inductor device having air gaps. However, the inductor device with the air gaps formed can have a high quality factor Q and inductance, but requires a highly difficult process. Further, the inductor device with the air gaps formed has an adhesion problem when the wet etching process is carried out for floating the structure in the air.

### SUMMARY OF THE INVENTION

The present invention has been developed in order to solve the above drawbacks and other problems associated with the conventional arrangement. A first aspect of the present invention is to provide an inductor device having a high quality factor Q and inductance by minimizing substrate losses occurring in the inductor device.

A second aspect of the present invention is to provide an inductor device having a flat dual structure.

A third aspect of the present invention is to provide an inductor device fabrication method capable of forming an air gap of more than a few hundred µm.

A fourth aspect of the present invention is to provide an inductor device capable of protecting an inductor from outside.

The foregoing and other aspects and advantages are realized by providing an inductor device, comprising a substrate etched away at predetermined intervals; first and second inductors formed on the top and bottom of the substrate, respectively; and a protection package for shielding at least one of the first and the second inductors from outside.

The first and second inductors are formed in a symmetrical structure with respect to the substrate, and the inductor device further comprises connection parts for electrically connecting the first and second inductors.

The inductor device may further comprise air gaps between the substrate, the first inductor, and the second inductor in order for the first and the second inductors to be exposed in the air.

The inductor device may further comprise a further protection package for shielding the other of the first and the second inductors from outside, and the further protection package has an electrode layer formed thereon at predetermined positions to supply electric currents to the inductor device.

Further, an inductor device fabrication method comprises forming a first inductor on top of a substrate, and forming a second inductor on a bottom of the substrate; etching away the substrate at predetermined intervals; and forming a protection package for hermetically sealing at least one of the first inductor and the second inductor for shielding the at least one of the first inductor and the second inductor from outside.

The substrate may be etched away by, for example, dry etching.

### BRIEF DESCRIPTION OF THE DRAWINGS

The above aspects and features of the present invention will be more apparent by describing exemplary embodiments of the present invention with reference to the accompanying drawings, in which:

FIG. 1 is a view for showing an inductor device fabricated according to a general method;

FIGs. 2A and 2B are views for showing an inductor device according to an embodiment of the present invention; and

FIGs. 3A through 3P are views for illustrating a process of fabricating an inductor device according to an embodiment of the present invention.

### DETAILED DESCRIPTION OF EXEMPLARY EMBODIMENTS

Hereinafter, the present invention will be described with reference to the accompanying drawings.

FIGs. 2A and 2B are views for showing an exemplary inductor device according to an embodiment of the present invention. The inductor device has a substrate 202, and first and second inductors 206 and 204 formed in a symmetrical structure on the upper and lower sides of the substrate 202. Further, the inductor device has a connection part 208 for connecting the first inductor 206 and the second inductor 204. As stated above, the inductor device forms a dual structure of the first and second inductors 206 and 204, so as to have a high inductance.

FIG. 2A is an inductor device not hermetically sealed, and FIG. 2B is a view for showing an inductor device hermetically sealed by protection packages 200 and 210.

The protection package 200 of FIG. 2A is fabricated in glass, and the substrate 202 is fabricated in silicon Si. The first and second inductors 206 and 204 are fabricated in metal substances such as copper Cu and the like. The inductor device has air gaps formed therein so that the first and second inductors 206 and 204 float from the substrate 202. The quality factors of the first and second inductors 206 and 204 can be improved due to the floating of the first and second inductors 206 and 204 from the substrate 202.

FIG. 2B shows that the first and second inductors 206 and 204 can be safely secured from external shocks since the first and second inductors 206 and 204 are hermetically sealed with the first and second protection packages 210 and 200. Further, electrode layers 212 are formed so that the first and second inductors 204 and 206 actually can be used.

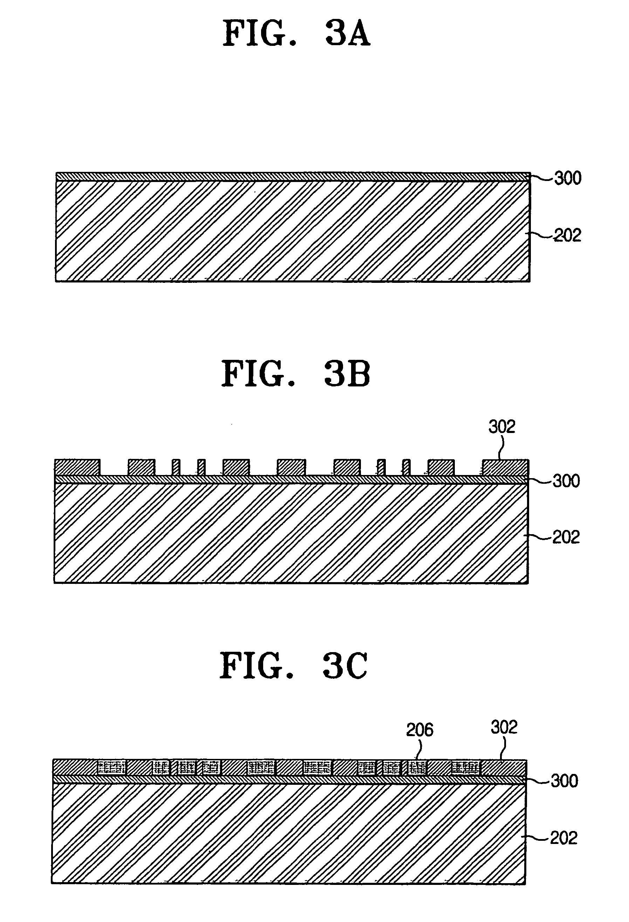

Hereinafter, detailed description will be made on the inductor device fabrication process according to an embodiment of the present invention with reference to FIGs. 3A-3P.

FIG. 3A is a view for showing a substrate 202 and a seed layer 300 coated on the top of the substrate 202. The seed layer 300 is made of a metal substance such as Titanium Ti, Chromium Cr, or the like. Description will be made later on the reason why the seed layer 300 is coated on the top of the substrate 202.

FIG. 3B is a view for showing photosensitive solution 302 coated on a region formed on the top of the seed layer 300. The shape of the first inductor is determined depending on a region on which the photosensitive solution 302 is coated.

FIG. 3C is a view for showing the electroplating of a metal substance on a region on which the photosensitive solution 302 is not coated. The electroplating of the metal substance forms the first inductor 206. In general, copper Cu is used as the metal substance, but copper can be replaced with any conductive substance depending on a user's requirement. The seed layer 300 performs a function of improving adhesive power of the metal substance (first inductor) 206 to the substrate 202. That is, if the seed layer 300 does not exist, the adhesive power of the metal substance 206 to the substrate 202 is deteriorated.

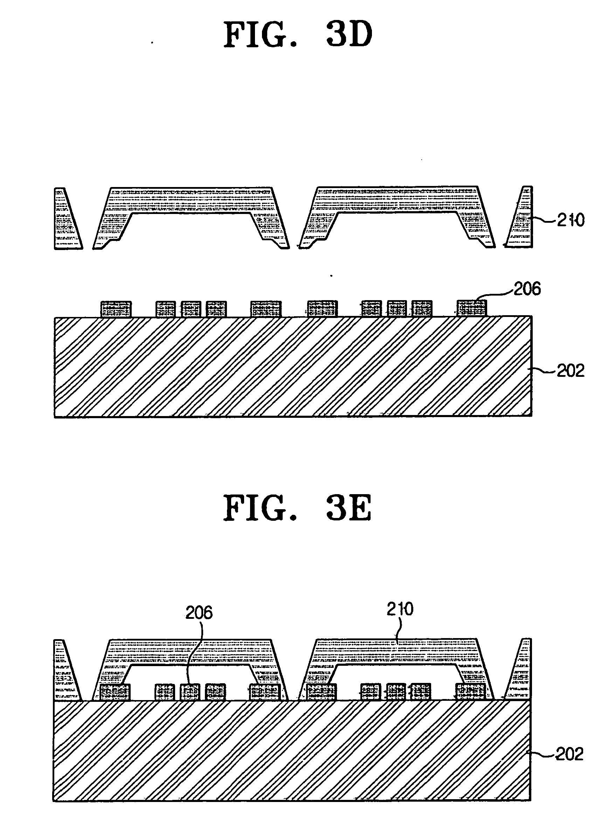

FIG. 3D is a view for showing the etching of the photosensitive solution 302 coated in FIG. 3B and the seed layer 300 coated in FIG. 3A. The etching of the photosensitive solution 302 forms the first inductor 206 of the inductor device. Hereinafter, description will be made on a process of hermetically sealing the first inductor 206 with the first protection package 210. FIG. 3D also shows the first protection package 210 to hermetically seal the first inductor 206. As stated above, the first protection package 210 is made of glass, but can be made of a different substance depending on the user's requirement.

FIG. 3E is a view for hermetically sealing the first inductor 206 with the first protection package 210. The first inductor 206 is hermetically sealed with the first protection package 210 by anodic bonding. In order to carry out the anodic bonding, a negative voltage is applied to the top of the first protection package 210 and a positive voltage is applied to the bottom of the substrate 202. For the sake of brevity, a detailed description of the carrying-out of the anodic bonding will be omitted. The first inductor 206 is hermetically sealed with the first protection package 210 by the anodic bonding.

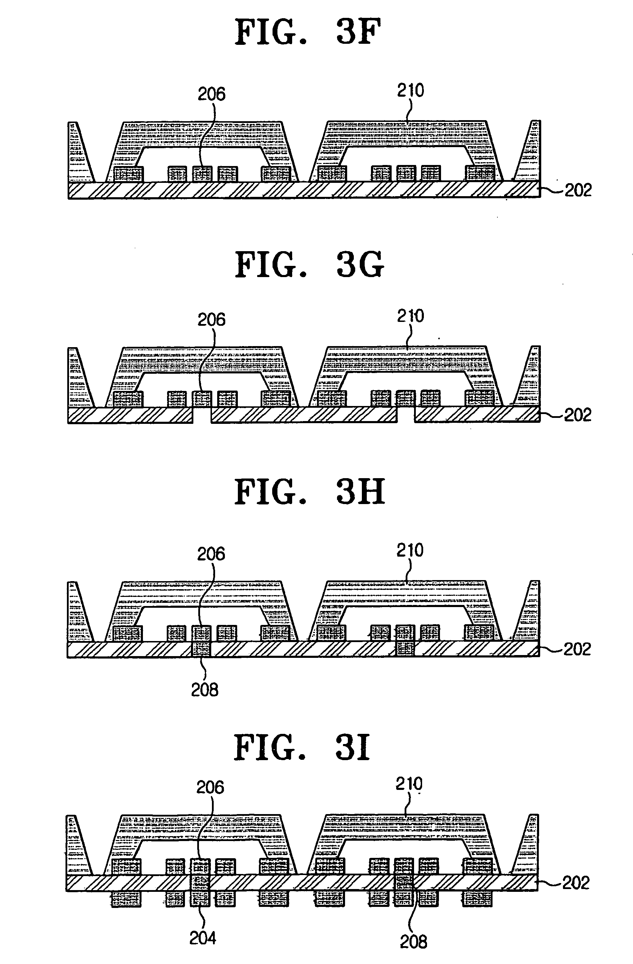

As shown in FIG. 3F, the substrate 202 is polished to a certain thickness. In general, the Chemical Mechanical Polishing (CMP) is used to polish the substrate 202. The flatness of the substrate 202 can be improved by the polishing of the substrate 202 by the CMP.

As shown in FIG. 3G, a portion of the substrate 202 is etched away to allow formation of a connection part 208 electrically connecting the first and second inductors 206 and 204. Further, FIG. 3G shows the etching of two regions to allow formation of two connection parts 208.

In FIG. 3H, the regions etched away in FIG. 3G are electroplated with a metal substance to form the regions as the connection parts 208. The electroplating process is the same as shown in FIG. 3C. Hereinafter, description will be made on a process of forming the second inductor 204.

In FIG. 3I, the second inductor 204 is formed. The process of forming the second inductor 204 is the same as the process carried out in FIGs. 3A to 3D.

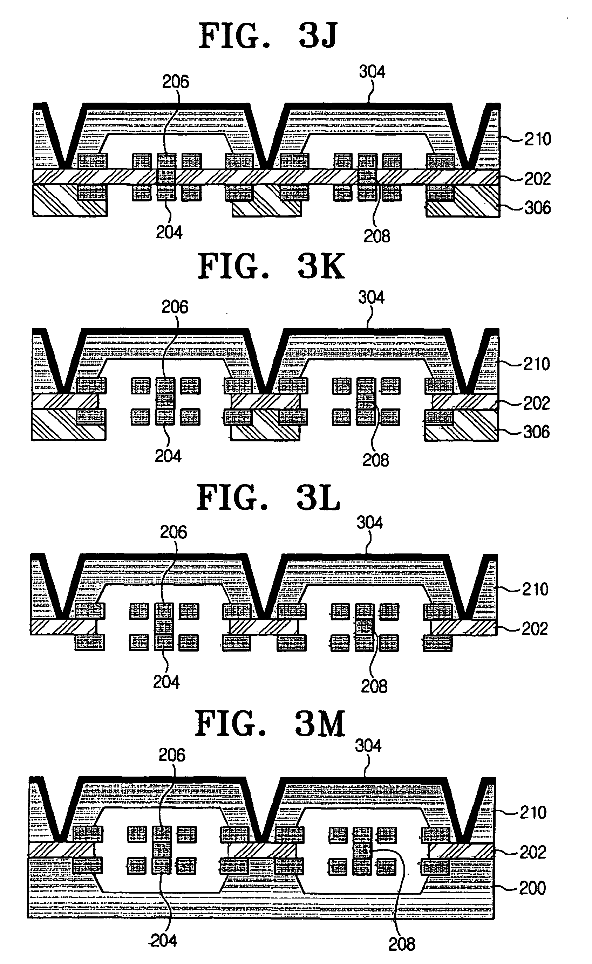

In FIG. 3J, the photosensitive solution (PR) 306 is coated on a portion of the second inductor 204. FIG. 3J shows three regions, that is, both end portions and a middle portion, coated with the photosensitive solution 306, for example. Further, a metal substance 304 is coated on the top of the first protection package 210. The metal substance can be replaced with the same substance as the metal substance 300 coated on the top of the substrate 202 of FIG. 3A. Further, the process of coating the metal substance 304 can be omitted depending on user's requirement, or performed at one of the next steps to be carried out.

In FIG. 3K, a dry release is used to etch away the regions not coated with the photosensitive solution 306. In particular, the dry release etches away the substrate 202 not coated with the photosensitive solution 306. Further, portions of the first and second inductors 206 and 204 can be etched away as the dry release is carried out. The dry-release process floats the first and second inductors 206 and 204 in the air.

In FIG. 3L, the photosensitive solution 306 coated in FIG. 3J is removed.

In FIG. 3M, the second protection package 200 is used to hermetically seal the second inductor 204. The process of hermetically sealing the second inductor 204 is the same as the process of hermetically sealing the first inductor 206.

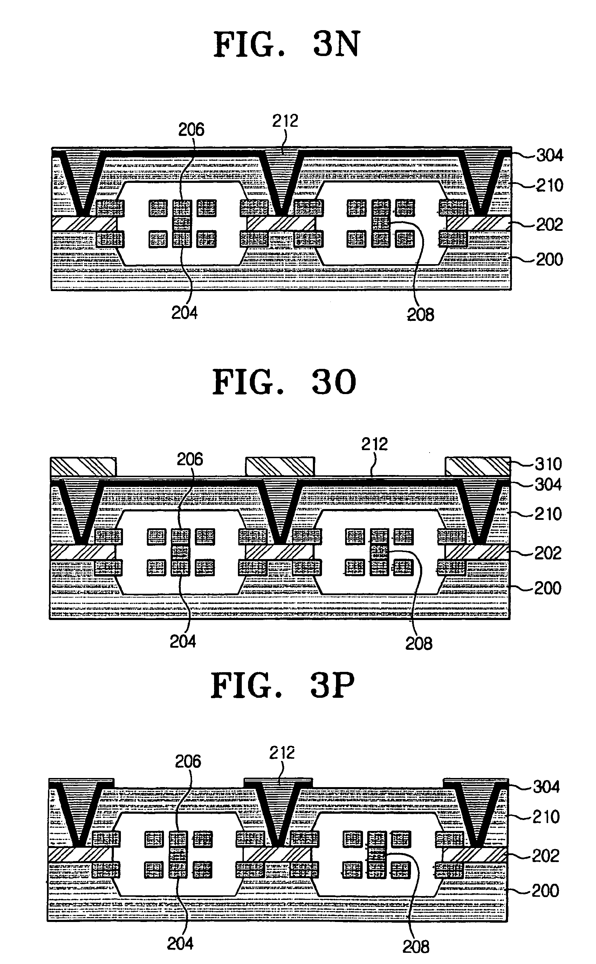

In FIG. 3N, electrodes are formed to supply electric currents to the first and second inductors 206 and 204. The electroplating is carried out to form the electrodes by filling a metal substance 212 in recess portions of the first protection package 210.

In FIG. 3O, the photosensitive solution 310 is coated on portions of the metal substance 212 to form the electrode layer 212 as in FIG. 2B.

FIG. 3P shows a process of forming the first protection package for protecting the first inductor. Further, if the metal substance 212 is etched away, the photosensitive solution 310 coated in FIG. 3O is eliminated.

FIGs. 3A-3P show a process of forming the first protection package for protecting the first inductor, but, depending on the user's requirement, the process can be omitted that forms the first protection package for protecting the first inductor as in FIG. 2A. That is, only the second protection package would be formed to protect the second inductor.

The process for an inductor device according to the fabrication method of the present invention enables the inductor device to have high inductance and quality factor. Further, the method enables the inductor device to have air gaps of more than a few hundred µm formed therein. The method employs the dry-etching process instead of the much more difficult wet-etching process, enabling the flat and dual-structured inductors to be easily fabricated. The formation of the protection packages can protect the inductors from external shocks.

## Claims

1. An inductor device, comprising:
an etched substrate (202);
first (206) and second (204) inductors formed on a top and a bottom of the substrate (202), respectively;
connection parts (208) for electrically connecting the first and second inductors; and
a protection package (200, 210) for shielding at least one of the first and the second inductors from outside;
**characterized by**
the substrate (202) being etched away at predetermined intervals, thereby providing a common air gap formed between the substrate, the first inductor (206) and the second inductor (204), in order for the first and the second inductors to be exposed in the air.

2. The inductor device as claimed in claim 1, wherein the first and second inductors are formed in a symmetrical structure with respect to the substrate.

3. The inductor device as claimed in claim 1, wherein a further protection package shields the other of the first and second inductors from outside.

4. The inductor device as claimed in claim 1, wherein the further protection package has an electrode layer (304) formed thereon at predetermined positions to supply electric currents to the inductor device.

5. A method for the production of an inductor device according to claim 1 comprising:
forming a first inductor (206) on the top of a substrate (202), and forming a second inductor (204) on the bottom of the substrate;
etching of the substrate;
electrically connecting the first and second inductors; and
forming a protection package (200, 210) for sealing at least one of the first inductor and the second inductor for shielding the at least one of the first inductor and the second inductor from outside;
**characterized in that**
the substrate is etched away at predetermined intervals, thereby forming a common air gap between the substrate, the first inductor and the second inductor, in order for the first and the second inductors to be exposed in the air.

6. The method as claimed in claim 5, wherein the first and second inductors are formed in a symmetrical structure with respect to the substrate.

7. The method as claimed in claim 5, wherein a further protection package is formed for hermetically sealing the other of the first and second inductors to shield the other of the first and second inductors from outside.

8. The method as claimed in claim 5, wherein an electrode layer is formed at predetermined positions on the further protection package, in order to supply electric currents to the inductor device.

9. The method as claimed in claim 5, wherein the substrate is etched by dry etching.

## Patentansprüche

1. Induktive Vorrichtung, die umfasst:
ein geätztes Substrat (202);
ein erstes (206) und ein zweites (204) induktives Element, die an einer Oberseite bzw. einer Unterseite des Substrats (202) ausgebildet sind;
Verbindungsteile (208) zum elektrischen Verbinden des ersten und des zweiten induktiven Elementes, und
ein Schutzgehäuse (200, 210) zum Abschirmen wenigstens des ersten oder des zweiten induktiven Elementes nach außen;
**dadurch gekennzeichnet, dass**
das Substrat (202) in vorgegebenen Intervallen weggeätzt ist, so dass ein gemeinsamer Luftspalt vorhanden ist, der zwischen dem Substrat, dem ersten induktiven Element (206) und dem zweiten induktiven Element (204) ausgebildet ist, so dass das erste und das zweite induktive Element an der Luft frei liegen.

2. Induktive Vorrichtung nach Anspruch 1, wobei das erste und das zweite induktive Element in einer symmetrischen Struktur in Bezug auf das Substrat ausgebildet sind.

3. Induktive Vorrichtung nach Anspruch 1, wobei ein weiteres Schutzgehäuse das andere von dem ersten und dem zweiten induktiven Element nach außen abschirmt.

4. Induktive Vorrichtung nach Anspruch 1, wobei das weitere Schutzgehäuse eine Elektrodenschicht (304) aufweist, die daran an vorgegebenen Positionen ausgebildet ist, um der induktiven Vorrichtung elektrische Ströme zuzuführen.

5. Verfahren zum Herstellen einer induktiven Vorrichtung nach Anspruch 1, das umfasst:
Ausbilden eines ersten induktiven Elementes (206) an der Oberseite eines Substrats (202) und Ausbilden eines zweiten induktiven Elementes (204) an der Unterseite des Substrats;
Ätzen des Substrats;
elektrisches Verbinden des ersten und des zweiten induktiven Elementes; und
Ausbilden eines Schutzgehäuses (200, 210) zum Kapseln wenigstens des ersten induktiven Elementes oder des zweiten induktiven Elementes, um das wenigstens eine von dem ersten induktiven Element und dem zweiten induktiven Element nach außen abzuschirmen;
**dadurch gekennzeichnet, dass**
das Substrat in vorgegebenen Intervallen weggeätzt wird, um so einen gemeinsamen Luftspalt zwischen dem Substrat, dem ersten induktiven Element und dem zweiten induktiven Element auszubilden, so dass das erste und das zweite induktive Element an der Luft frei liegen.

6. Verfahren nach Anspruch 5, wobei das erste und das zweite induktive Element in einer symmetrischen Struktur in Bezug auf das Substrat ausgebildet werden.

7. Verfahren nach Anspruch 5, wobei ein weiteres Schutzgehäuse ausgebildet wird, um das andere von dem ersten und dem zweiten induktiven Element hermetisch zu kapseln und das andere von dem ersten und dem zweiten induktiven Element nach außen abzuschirmen.

8. Verfahren nach Anspruch 5, wobei eine Elektrodenschicht am vorgegebenen Positionen an dem weiteren Schutzgehäuse ausgebildet wird, um der induktiven Vorrichtung elektrische Ströme zuzuführen.

9. Verfahren nach Anspruch 5, wobei das Substrat durch Trockenätzen geätzt wird.

## Revendications

1. Dispositif inductif, comprenant :
un substrat gravé (202),
des première (206) et deuxième (204) bobines d'inductance formées sur une partie supérieure et une partie inférieure du substrat (202), respectivement,
des parties de connexion (208) destinées à connecter électriquement les première et deuxième bobines d'inductance, et
un boîtier de protection (200, 210) destiné à protéger au moins une première des première et deuxième bobines d'inductance par rapport à l'extérieur,
**caractérisé par**
**le fait que** le substrat (202) fait l'objet d'un enlèvement de matière par gravure à des intervalles prédéterminés, en fournissant de cette manière un entrefer commun formé entre le substrat, la première bobine d'inductance (206) et la deuxième bobine d'inductance (204), afin que les première et deuxième bobines d'inductance soient exposées à l'air.

2. Dispositif inductif selon la revendication 1, dans lequel les première et deuxième bobines d'inductance sont formées suivant une structure symétrique par rapport au substrat.

3. Dispositif inductif selon la revendication 1, dans lequel un autre boîtier de protection protège l'autre des première et deuxième bobines d'inductance de l'extérieur.

4. Dispositif inductif selon la revendication 1, dans lequel l'autre boîtier de protection a une couche d'électrode (304) formée sur celui-ci à des positions prédéterminées pour fournir des courants électriques au dispositif inductif.

5. Procédé de production d'un dispositif inductif selon la revendication 1, comprenant les étapes consistant à :
former une première bobine d'inductance (206) sur la partie supérieure d'un substrat (202), et former une deuxième bobine d'inductance (204) sur la partie inférieure du substrat,
graver le substrat,
connecter électriquement les première et deuxième bobines d'inductance, et
former un boîtier de protection (200, 210) pour sceller au moins une première de la première bobine d'inductance et de la deuxième bobine d'inductance pour protéger la au moins une première de la première bobine d'inductance et de la deuxième bobine d'inductance de l'extérieur,
**caractérisé en ce que**
le substrat fait l'objet d'un enlèvement de matière par gravure à des intervalles prédéterminés, en formant de cette manière un entrefer commun entre le substrat, la première bobine d'inductance et la deuxième bobine d'inductance, afin que les première et deuxième bobines d'inductance soient exposées à l'air.

6. Procédé selon la revendication 5, dans lequel les première et deuxième bobines d'inductance sont formées suivant une structure symétrique par rapport au substrat.

7. Procédé selon la revendication 5, dans lequel un autre boîtier de protection est formé pour sceller de manière hermétique l'autre des première et deuxième bobines d'inductance pour protéger l'autre des première et deuxième bobines d'inductance de l'extérieur.

8. Procédé selon la revendication 5, dans lequel la couche d'électrode est formée à des positions prédéterminées sur l'autre boîtier de protection, de manière à fournir des courants électriques au dispositif inductif.

9. Procédé selon la revendication 5, dans lequel le substrat est gravé par gravure sèche.
